# FASCICULE DE BREVET EUROPEEN

(11) **EP 2 620 984 B1**
(45) Date de publication et mention de la délivrance du brevet: **07.09.2016**
(21) Numéro de dépôt: 13152758.2
(22) Date de dépôt: 25.01.2013
(51) Int. Cl.: H01L 29/78, H01L 29/66, H01L 21/762, H01L 29/10, H01L 21/02, H01L 29/786, H01L 21/66

(54) **Procédé pour contraindre un motif mince et procédé de fabrication de transistor integrant ledit procédé**
Verfahren zur Deformierung eines Dünnfilmmusters, und Herstellungsverfahren von Transistoren, bei dem dieses Verfahren umgesetzt wird
Method for straining a thin pattern and method for manufacturing a transistor including said method

(30) Priorité: 30.01.2012 FR 1250841
(43) Date de publication de la demande: 31.07.2013
(73) Titulaire: COMMISSARIAT A L'ENERGIE ATOMIQUE ET AUX ENERGIES ALTERNATIVES, 75015 Paris (FR)
(72) Inventeur: Morvan, Siméon, 38000 GRENOBLE (FR); Andrieu, François, 38000 GRENOBLE (FR); Barbe, Jean-Charles, 38160 IZERON (FR)
(74) Mandataire: Esselin, Sophie

(56) Documents cités:
- US-A1- 2004 173 812
- US-A1- 2006 163 557
- US-A1- 2007 215 859
- US-B1- 7 851 325
- US-B1- 8 124 470

## Description

Le domaine de l'invention est celui des matériaux semi-conducteurs notamment utilisés dans la microélectronique.

Les circuits intégrés sont généralement fabriqués sur des substrats en silicium. Des substrats de type « SOI » pour « Silicon On Insulator » correspondant à des substrats de silicium incorporant une couche d'oxyde de silice SIO₂ sont couramment utilisés dans l'industrie de la microélectronique et ce notamment pour la fabrication de transistors, permettant la réduction de courants de fuite.

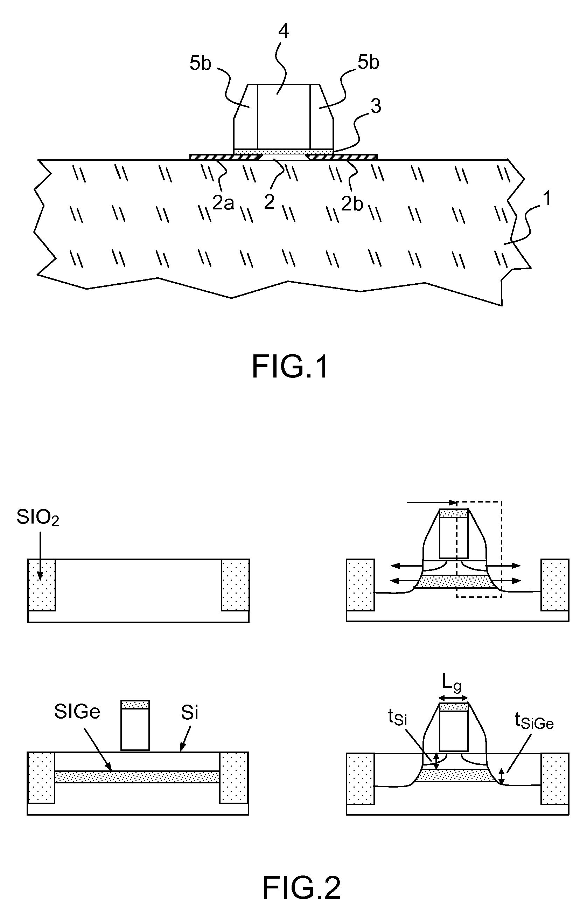

La figure 1 illustre un schéma de transistor classique réalisé à partir d'un substrat semiconducteur 1, et comprenant de manière classique une source 2a, un drain 2b et une grille 4, ladite grille étant séparée d'un canal conducteur 2, par un matériau isolant 3 encore appelé isolant de grille, et comprenant des éléments 5a et 5b appelés espaceurs isolants, notamment décrit dans une demande de brevet FR 2 872 626 du Demandeur.

Classiquement, le matériau semi-conducteur est localement dopé de manière à définir les régions correspondant à la source et au drain. Cette opération de dopage peut notamment être réalisée par implantation ionique, la nature de l'espèce ionique implantée, de type donneur ou accepteur d'électrons définissant la nature du transistor : transistor respectivement appelé NMOS ou PMOS.

Afin d'augmenter les performances en termes de mobilité et de porteurs d'un transistor, il a déjà été montré qu'il était possible d'agir sur les contraintes exercées au niveau de la couche de silicium (ou de tout autre matériau semi-conducteur) du substrat SOI, pour augmenter la mobilité des porteurs grâce à l'effet d'une contrainte mécanique sur un matériau semi-conducteur générant une amélioration très forte de la mobilité des porteurs et donc les performances électriques des transistors.

Le demandeur a notamment déposé la demande de brevet FR 2 872 626 relative à un procédé permettant de contraindre ou de déformer un motif ou une couche mince à partir d'un composant initial comportant une couche précontrainte. Ce procédé comporte une étape de gravure de la couche précontrainte perpendiculairement à sa surface. Cette couche précontrainte peut être isolante ou conductrice mais, pour des applications telles que le contrôle des propriétés de transport par déformation du canal d'un transistor MOS, elle est de préférence électriquement isolante (par exemple en Si₃N4), afin de limiter les courants de fuite.

D'autres auteurs : J.G. Fiorenza « Detailed Simulation Study of a Reverse Embedded-SiGe Strained-Silicon MOSFET » IEEE Transactions on Electron Devices; Vo1.55, No.2, p.640; 2008, ont proposé sur un principe similaire, de transférer de la contrainte dans le canal : une couche de SiGe avec une concentration en Germanium de 35%, en compression induit une tension dans le canal juste au dessus, des simulations permettant d'optimiser le processus avec certains paramètres physiques et d'architecture de structure, comme illustré en figure 2.

Les simulations de cette publication montrent une optimisation suivant deux critères : - la maximisation du rapport de l'épaisseur de la couche de SiₓGey (tSiGe) sur l'épaisseur de la couche supérieure de Si (tSi) ; - le rapport d'aspect AR= (tSiGe+tSi)/W avec W la longueur du motif réalisé, tel que 0.3<AR<0.5.

Selon cette structure, il existe un avantage uniquement d'un point du point de vue de la contrainte : l'absence de couche enterrée d'oxyde entre le silicium et la couche précontrainte facilite le transfert de contrainte. Néanmoins, des inconvénients demeurent :
- la couche contrainte de SiGe a la même dimension que la grille avec l'espaceur ce qui est inférieur à la dimension de la zone active dans le cas d'une structure de transistor alors que la diminution de cette dimension est un facteur de réduction de la contrainte transmise.
- la gravure de la couche précontrainte se passe après l'étape de dépôt grille. Des auteurs ont également décrit dans la demande de brevet US 2006/0163557 des structures complexes Le document US 7 851 325 B1 décrit un procédé pour contraindre un motif dans une couche de matériau semi-conducteur à la surface d'un empilement de couches comprenant une couche contrainte d'alliage SixGey et une couche de diélectrique enterrée présentant une succession de plusieurs couches de SiGe.

Dans ce contexte, le Demandeur propose de graver lesdites couches dans des zones périphériques plus éloignées du canal dans lequel on veut répercuter la contrainte et de manière plus générale dans le motif auquel on s'intéresse. Dans le cas d'une structure de transistor, la gravure est ainsi réalisée en périphérie des zones destinées à des fonctions de source et de drain et non juste au niveau de la région destinée à la fonction de grille. Par ailleurs, le Demandeur s'est attaché à des structures comportant non seulement une couche contrainte d'alliage de SiGe mais également une couche d'oxyde de silicium située entre ladite couche contrainte et ladite couche de silicium dans laquelle on veut transférer ladite contrainte, de manière à ne pas transférer des problèmes de dislocations susceptibles d'intervenir depuis la couche contrainte dans des conditions limites vers la couche de silicium, comme il sera explicité plus en détails dans la suite de la description.

C'est pourquoi et plus précisément, la présente invention a pour objet un procédé pour contraindre un motif présentant une surface dite de motif, dans une couche de matériau semiconducteur pouvant être en silicium à la surface d'un empilement de couches élaboré à la surface d'un substrat, ledit empilement comprenant au moins une couche contrainte d'alliage SiₓGe_{y} avec x et y des fractions molaires et une couche d'oxyde de silicium enterrée, caractérisé en ce que :
- il comporte la gravure en périphérie d'une surface de dimensions supérieures à celles de ladite surface de motif, de la couche d'oxyde de silicium enterrée et de la couche contrainte d'alliage SiₓGe_{y} sur au moins une partie de la profondeur de ladite couche d'alliage ;
- la couche d'oxyde de silicium enterrée (BOX) étant située entre ladite couche de matériau semiconducteur pouvant être en silicium et ladite couche contrainte d'alliage SiₓGe_{y}.

Selon une variante de l'invention, la fraction molaire y est égale à 1-x.

Selon une variante de l'invention, l'alliage SiₓGe_{y} est dopé.

Selon une variante de l'invention, l'épaisseur de la couche d'alliage SiₓGe_{y} est sensiblement égale à l'épaisseur critique au-delà de laquelle sont susceptibles d'apparaître des dislocations dans ladite couche d'alliage SiₓGe_{y}.

Selon une variante de l'invention, le procédé comprend la détermination :
- d'une première fonction t_{SiGe} = f (W), relative à l'évolution de d'une épaisseur optimale de la couche d'alliage SiₓGe_{y} (t_{SiGe}) en fonction d'une dimension de motif (W), permettant d'obtenir une contrainte maximum (SO_{ZZ}) dans ledit motif, ladite épaisseur optimale étant indépendante de la fraction molaire y
- d'une seconde fonction tc_{SiGe} = g (y) relative à l'évolution de l'épaisseur critique de la couche d'alliage SiₓGe_{y} au-delà de laquelle des dislocations apparaissent dans ladite couche contrainte pour une fraction molaire y donnée ;
- la détermination d'une fraction molaire y par égalité des épaisseurs t_{SiGe} = tc_{SiGe}, permettant de définir pour une dimension de motif donnée, un couple optimal de valeurs (t_{SiGe}, y).

Selon une variante de l'invention, la gravure est effectuée également dans une partie dudit substrat sur une profondeur de gravure non nulle, de manière à augmenter le transfert de contrainte.

L'invention a aussi pour objet un procédé de fabrication de transistor caractérisé en ce qu'il comprend le procédé pour contraindre un motif selon la présente invention et comprenant la gravure d'une zone active dont la dimension selon la direction du courant dans le plan des couches est au moins supérieure ou égale à la somme des dimensions d'une zone de source, d'une zone de grille et d'une zone de drain.

Selon une variante de l'invention, le procédé comprend :
- une étape de dépôt d'une couche de nitrure de silicium, postérieure à l'étape de gravure de la zone active ;
- une étape de dépôt épais de couche d'oxyde ;
- la réalisation de plots d'isolation d'oxyde de part et d'autre des zones de source, grille et drain, permettant de définir des plots d'oxyde selon un procédé proche d'un procédé classique STI.

L'invention sera mieux comprise et d'autres avantages apparaîtront à la lecture de la description qui va suivre donnée à titre non limitatif et grâce aux figures annexées parmi lesquelles :
- la figure 1 illustre un schéma de transistor classique décrit dans la demande de brevet FR 2 872 626 ;
- la figure 2 illustre une structure de transistor avec une couche contrainte en SiGe selon l'art connu ;
- les figures 3a, 3b et 3c illustrent une structure pouvant être optimisée selon le procédé de la présente invention dans le cas d'une structure de transistor ;
- la figure 4 illustre l'évolution de la contrainte S0_{ZZ} selon la largeur du motif contraint, et ce pour différentes profondeurs de gravure dans le substrat Si en dessous de la couche précontrainte de SiₓGe_{y} ;
- la figure 5 illustre l'évolution de la contrainte S0_{ZZ} en fonction de la largeur du motif contraint et ce pour différentes concentrations en germanium dans une couche d'alliage SiₓGe_{y} ;
- la figure 6 illustre pour un ensemble de dimensions données de motif contraint, l'évolution de la contrainte S0_{ZZ} en fonction de l'épaisseur de la couche d'alliage de silicium et de germanium ;
- la figure 7 illustre la relation linéaire existant entre l'épaisseur de la couche d'alliage en silicium et germanium et la dimension du motif contraint, pour une contrainte maximale ;
- la figure 8 illustre l'évolution de l'épaisseur critique d'une couche d'alliage de silicium et de germanium en fonction de la concentration en germanium dans l'alliage ;
- la figure 9 schématise une étape du procédé selon l'invention dans laquelle on reporte la relation linéaire telle qu'illustrée en figure 8 pour déterminer une fraction molaire en germanium dans l'alliage et correspondant à une valeur d'épaisseur critique ;
- la figure 10 illustre un exemple de profil de contrainte avec une épaisseur de 80nm de SiN lors d'une opération de gravure dans un procédé de l'invention ;
- les figures 11 a à 11 f illustrent les différentes étapes d'un procédé de fabrication d'un transistor utilisant le procédé de l'invention ;
- la figure 12 illustre un second empilement de couches utilisé dans un exemple de procédé de l'invention.

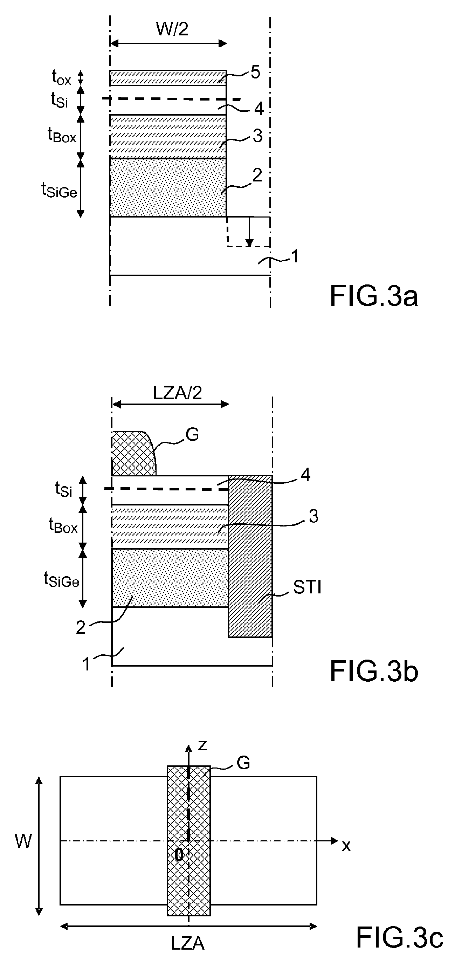

Selon le procédé de la présente invention, on élabore une structure comprenant sur un substrat 1, une couche précontrainte 2 de SiₓGe_{y}, une couche d'oxyde enterrée 3 encore dénommée Box, elle-même en contact avec la couche de silicium 4 dans laquelle on cherche à réaliser un motif comprenant un transfert de contrainte et ce en gravant en périphérie ladite structure, et une couche 5 d'oxyde natif qui se serait formé, comme l'illustre la figure 3a qui met par ailleurs en évidence :
- l'épaisseur de la couche précontrainte d'alliage de SiGe : t_{SiGe} ;
- l'épaisseur de la couche d'oxyde : t_{Box} ;
- l'épaisseur de la couche de silicium : t_{Si} ;
- l'épaisseur de la couche d'oxyde supérieure tₒₓ ;
- la profondeur de gravure dans le substrat t_{etch}.

La structure étudiée permet de transférer la contrainte dans un film mince de silicium ou de tout autre semi-conducteur. Pour cela la couche précontrainte de SiₓGe_{y} en compression est légèrement relaxée lors de la gravure définissant les zones actives. Une contrainte en tension est alors induite dans les couches supérieures et notamment dans le silicium à travers la couche isolante mince enterrée (Box). Cette structure vise l'amélioration de la mobilité des porteurs grâce à une contrainte en tension dans les transistors FDSOI pour les noeuds avancés (sub-22nm).

La figure 3b illustre une demie structure de ce type de transistor, mettant en évidence la grille et les plots isolants STI « shallow trench isolation », selon des structures connues de transistors individuels isolés entre eux par des plots d'oxyde isolants.

La couche précontrainte de SiₓGe_{y} en compression est au moins partiellement relaxée lors de la gravure définissant les zones actives. Une contrainte en tension est alors induite dans les couches supérieures et notamment dans le silicium à travers la couche isolante mince Box.

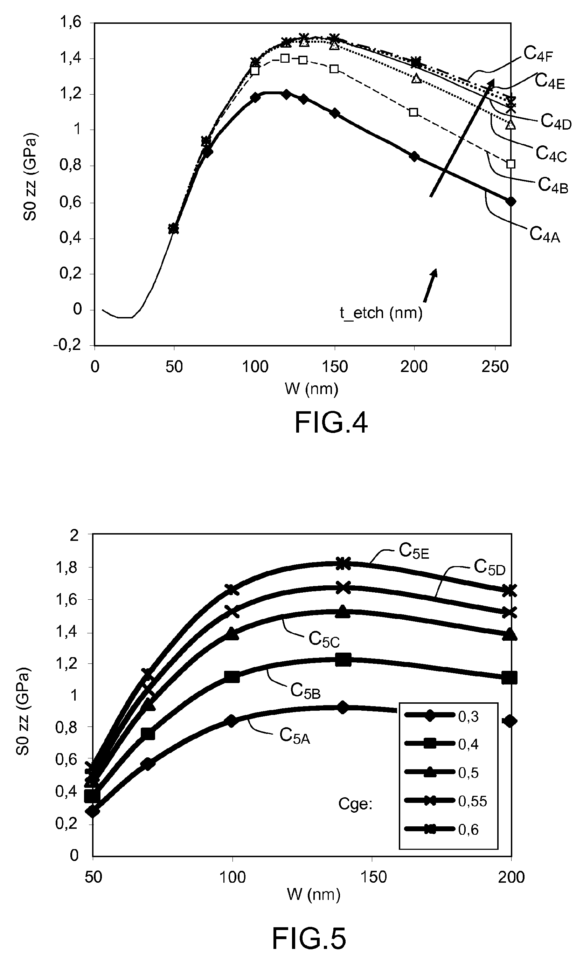

Le Demandeur a mis en évidence qu'il était possible de renforcer la contrainte au centre de la couche de Si en gravant également partiellement le substrat sur une profondeur de gravure comme l'illustre les résultats de la figure 4, les courbes C_{4A}, C_{4B}, C_{4C}, C_{4D}, C_{4E} et C_{4F} étant relatives à différentes profondeurs croissantes de gravure respectivement de 0nm, 10 nm, 30 nm, 50 nm, 70 nm et 200 nm.

Le Demandeur a par ailleurs mis en évidence que l'alliage SiₓGe_{y} possède une forte contrainte intrinsèque modulable avec la concentration de Ge comme l'illustrent les courbes de la figure 5 relatives à l'évolution de la composante de stress suivant l'axe z, S0_{ZZ} en GPa au centre de la zone active dans la couche supérieure de silicium, pour une longueur W de motif et ce pour différentes concentrations y en Germanium dans l'alliage SiₓGe_{y}. Les courbes C_{5A}, C_{5B}, C_{5C}, C_{5D} et C_{5E} sont respectivement relatives à des fractions molaires de 0,6, 0,55, 0,5, 0,4 et 0,3.

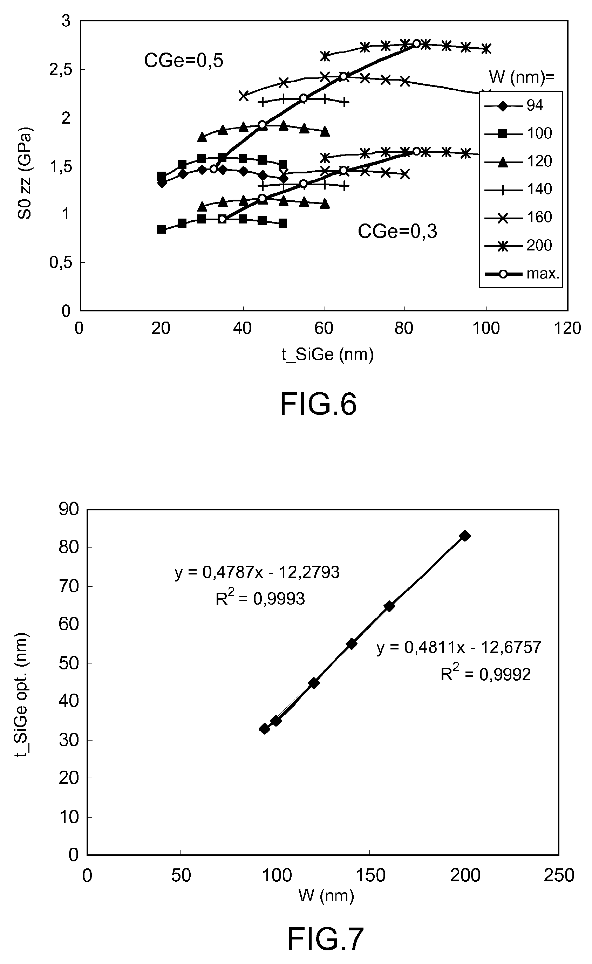

Le Demandeur a mis en évidence que pour chaque dimension W de motif contraint, il existe une épaisseur optimale de SiₓGe_{y} permettant d'obtenir un maximum pour la composante de stress suivant l'axe z, S0_{ZZ} en GPa. Les différentes courbes sont respectivement relatives à des motifs de dimension W égale à : 94 nm, 100 nm, 120 nm, 140 nm, 160 nm et 200 nm, il est alors possible de définir des courbes passant par les maxima de ces contraintes pour deux exemples de concentrations molaires en germanium respectivement de 0,3 et 0,5 comme montré sur la figure 6.

La valeur de W correspondant à cet optimum de contrainte est indépendant de la concentration, mettant en évidence qu'il est possible d'établir une relation linéaire entre l'épaisseur de la couche d'alliage pour laquelle la contrainte est maximale en fonction de la largeur du motif comme l'illustre la figure 7. La contrainte au milieu du film de silicium augmente avec la concentration de germanium et avec l'épaisseur de l'alliage en SiGe mais les propriétés de ce matériau imposent une épaisseur critique au-delà de laquelle des dislocations apparaissent et où la contrainte n'est plus maintenue. Il est à noter que la couche précontrainte 2 étant située sous la couche d'oxyde 3, cette dernière prévient de toute propagation de dislocation de la couche 3 vers le film silicium 4.

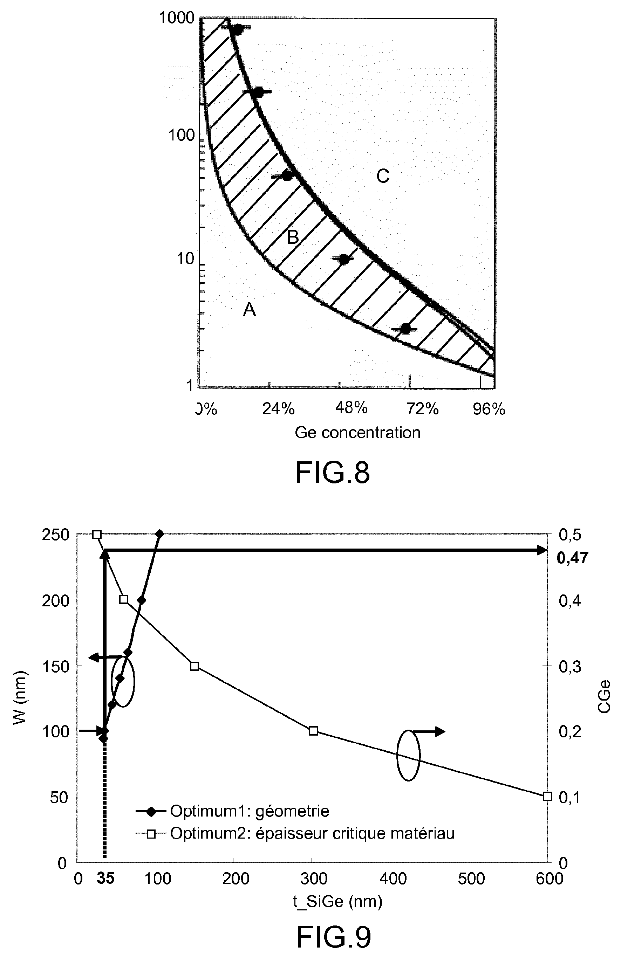

A ce titre, la figure 8 illustre des données de la littérature relatives à des épaisseurs critiques de relaxation plastique d'alliage SiGe en fonction de la concentration en germanium. Cette épaisseur critique diminue lorsque la concentration en Germanium augmente, cette dernière est donnée à titre illustratif, son estimation variant selon les sources dans la littérature. La zone A correspond à une zone dans laquelle l'alliage SiₓGe_{y} est contraint. La zone C correspond à une zone dans laquelle l'alliage SiₓGe_{y} est relaxé, la zone B correspondant à une zone intermédiaire dans laquelle l'alliage SiₓGe_{y} est dit métastable.

Ainsi, en mettant à profit le fait que la couche d'oxyde enterré 3 prévient la propagation des dislocations de la couche précontrainte 2 vers le film de silicium 4, il peut être avantageusement utilisé une couche précontrainte 2 dont l'épaisseur est supérieure à l'épaisseur critique tc_{SiGe}.

En effet selon la référence J. Appl. Phys. 110, 083829 (2011) et se référant à la figure 3 de cette même référence, une couche précontrainte contenant 52% de Germanium et d'épaisseur égale à 40nm peut être préférée à une couche précontrainte de même épaisseur mais contenant moins de 44% de Germanium ; la couche précontrainte contenant 52% de germanium conservant 85% de sa déformation nominale reste donc le lieu d'une énergie élastique transférable vers le film de silicium 2 supérieure à celle d'une couche de concentration inférieure à 44% et ce même si celle-ci ne relaxe pas une partie de son énergie élastique par émission de dislocation.

### Premier exemple de mise en application du procédé de l'invention pour définir une contrainte bi-axiale optimale au sein d'un canal de transistor

On réalise une structure telle que celle illustrée en figure 3, comprenant à la surface d'un substrat en silicium, une couche d'alliage en SiₓGe_{y} d'épaisseur t_{SiGe}, une couche d'oxyde enterrée BOX d'épaisseur t_{BOX}, une couche de silicium d'épaisseur t_{Si}, dans laquelle on cherche à créer une contrainte optimisée, recouverte d'une couche supérieure d'oxyde d'épaisseur tₒₓ, avec une dimension de motif W déterminée par les fonctions que l'on souhaite utiliser. De manière générale, les données t_{BOX}, t_{Si}, et tₒₓ, sont plus ou moins préalablement définies et l'on cherche selon le procédé de la présente invention à optimiser à partir de ces paramètres d'entrée fixés, selon la dimension W le couple : fraction y / épaisseur t_{SiGe}. La couche de SiₓGe_{y} peut être obtenue par des techniques classiques d'épitaxie.

La figure 9 illustre plus précisément comment le procédé de la présente invention permet d'optimiser les conditions d'élaboration des couches en fonction d'une dimension de motif donnée W. Il s'agit de mettre en relation les deux courbes d'optimum : la courbe correspondant plus précisément à la droite illustrée en figure 7 et relative à la variation de l'épaisseur de la couche d'alliage en SiₓGe_{y} en fonction de la dimension de motif contraint et la courbe d'épaisseur critique jusqu'à laquelle on peut pousser la concentration en germanium dans l'alliage. Par exemple pour une dimension W=100nm, l'épaisseur de SiGe optimale par rapport à la géométrie de la structure est de 35nm (droite de la figure 7 reportée). Puis pour cette même épaisseur, (comme indiqué par la flèche ascendante) la concentration maximale est déterminée par les propriétés de l'alliage SiGe (deuxième courbe : dénommée optimum 2) dans le cas présent conduisant à déterminer une concentration de 0,47 en germanium.

Ainsi selon cet exemple pour une dimension prédéterminée de motif, on est en mesure selon le procédé de l'invention de déterminer un couple de valeurs en termes d'épaisseur de couche d'alliage et de concentration en germanium dans l'alliage de manière à obtenir une composante de stress maximale au niveau de la couche dans laquelle le motif est réalisé, soit la couche 4.

Selon le présent exemple, dans le cas d'une zone active rectangulaire W=L=100nm le stress biaxial au centre est de 1,4GPa. Cette taille se rapproche de la zone active des nMOSFETs pour les circuits logiques.

Lorsque les conditions optimales d'élaboration sont définies, il convient de manière classique de réaliser un ensemble plots d'isolation de SiO₂ permettant de séparer des zones actives de transistor. Pour cela on utilise couramment une couche d'arrêt de polissage de nitrure de silicium SiN.

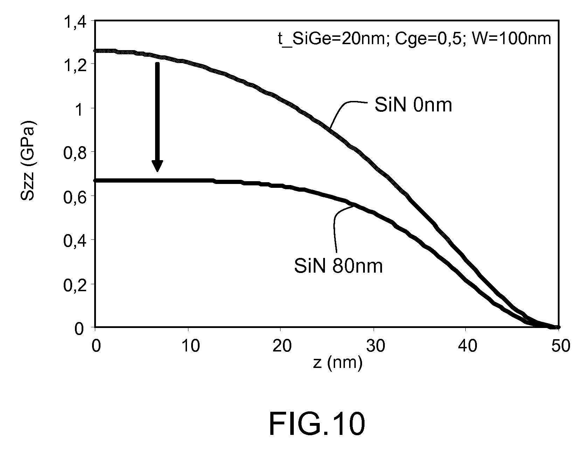

Néanmoins comme l'illustre la figure 10 relative à l'évolution de la composante de stress en fonction de l'épaisseur de SiN lors de la gravure, la présence de couches au dessus de la couche de silicium dans laquelle est contraint le motif, limite fortement le transfert de contrainte.

Le Demandeur propose une optimisation dans l'enchaînement classique des étapes pour réaliser une architecture de type STI afin d'éviter le dépôt de SiN (de l'ordre de 80nm) avant gravure. Selon cette technique classique, le substrat de silicium est recouvert d'une couche de nitrure de silicium. Cette couche est ainsi que les couches sous-jacentes sont gravées en dehors des motifs définissant les zones actives. Ensuite, les tranchées dans le silicium sont remplies d'oxyde de silicium.

On peut avantageusement utiliser un procédé de type CMP « chemical mechanical polishing » de polissage mécano-chimique, permettant d'éliminer tout l'oxyde au dessus de la surface de nitrure en ne conservant que de plots d'isolation en oxyde de silicium entre les zones actives de transistor.

Ainsi l'enchaînement classique des différentes étapes est le suivant :
- le dépôt d'une couche d'arrêt de polissage SiN ;
- la gravure de la zone active ;
- le remplissage par de l'oxyde (STI) ;
- le polissage jusqu'à la couche de SiN (CMP) ;
- le retrait du masque de SiN.

Selon la présente invention il est proposé de procéder au préalable à la gravure en périphérie d'une surface de dimensions supérieures aux dimensions du motif contraint.

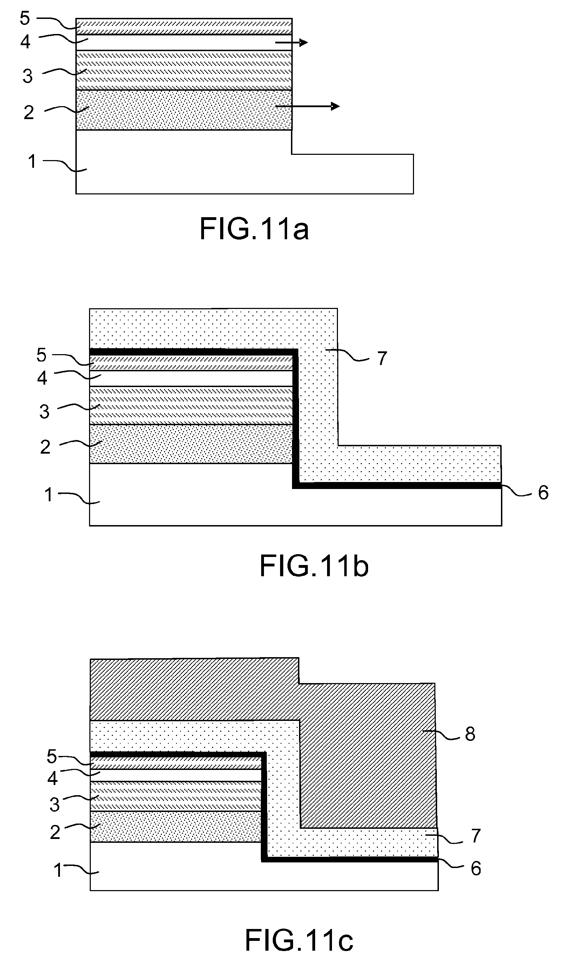

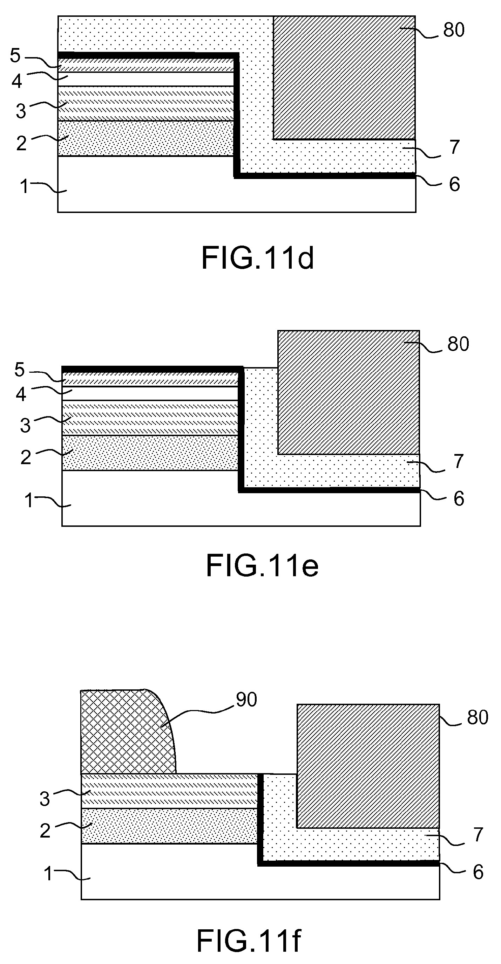

Un exemple de procédé de fabrication de transistor est à ce titre illustré grâce aux figures 11 a à 11 f.

On réalise l'empilement de couches suivantes sur un substrat de silicium 1 :
- une couche 2 d'alliage de SiₓGe_{y} ;
- une couche 3 d'oxyde enterrée :
- une couche 4 de silicium correspondant à la couche à l'intérieur de laquelle on cherche à optimiser une contrainte ;
- une couche supérieure d'oxyde 5.

On procède alors à une opération de gravure comme illustré en figure 11 a qui permet d'optimiser la valeur de la contrainte selon l'enseignement illustré par les courbes de la figure 4.

On procède à la réalisation d'une couche isolante 6 suivie du dépôt d'une couche 7 de nitrure de silicium, comme illustré en figure 11 b.

On procède alors à la réalisation d'un dépôt épais d'oxyde de silicium 8, comme illustré en figure 11c, correspondant à l'oxyde des plots STI.

On procède alors à une opération classique de polissage de type CMP par exemple, jusqu'à dégager la couche de nitrure de silicium comme illustré en figure 11 d.

On procède alors au retrait du nitrure de silicium et de la couche d'isolant au dessus de la couche active de silicium dans laquelle est transférée la contrainte et correspondant à une zone dite de grille, comme illustré en figure 11e.

On positionne la grille 90, en regard de ladite zone de grille, comme illustré en figure 11 f.

### Second exemple de mise en application du procédé de l'invention pour définir une contrainte bi-axiale optimale au sein d'un canal de transistor :

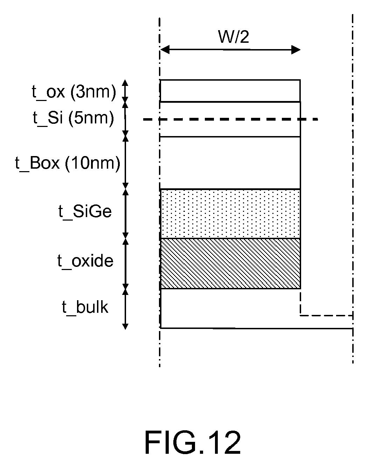

Selon ce second exemple, on peut aussi réaliser l'empilement illustré en figure 12 comprenant : le substrat Si d'épaisseur t_{bluk}/ un premier oxyde enterré d'épaisseur t_{oxide} / la couche d'alliage SiₓGe_{y} précontrainte d'épaisseur t_{SiGe}/ le second oxyde enterré Box d'épaisseur t_{BOx}/ le film de silicium d'épaisseur t_{Si} / une couche d'oxyde d'épaisseur tₒₓ.

On peut réaliser ce type d'empilement par des techniques connues de condensation telles que décrites notamment dans l'article de B. Vincent et al.; "Fabrication of SiGe-on-insulator substrates by a condensation technique: an experimental and modelling study"; Semicond. Sci. Technol. , 22, (2007), 237-244.

## Revendications

1. Procédé pour contraindre un motif présentant une surface dite de motif, dans une couche de matériau semiconducteur pouvant être en silicium à la surface d'un empilement de couches élaboré à la surface d'un substrat, ledit empilement comprenant au moins une couche contrainte d'alliage SiₓGe_{y} avec x et y des fractions molaires et la fraction molaire y étant égale à 1-x, et une couche d'oxyde de silicium enterrée (BOX), **caractérisé en ce que** :
- il comporte la gravure en périphérie d'une surface de dimensions supérieures à celles de ladite surface de motif, de la couche d'oxyde de silicium enterrée et de la couche contrainte d'alliage SiₓGe_{y} sur la profondeur de ladite couche d'alliage ;
- la couche contrainte de SiₓGe_{y} en compression étant au moins partiellement relaxée lors de la gravure définissant les zones actives, une contrainte en tension étant induite dans la couche de matériau semiconducteur pouvant être en silicium
- la couche d'oxyde de silicium enterrée (BOX) étant située entre ladite couche de matériau semiconducteur pouvant être en silicium et ladite couche contrainte d'alliage SiₓGe_{y}.

2. Procédé pour contraindre un motif dans une couche de matériau semiconducteur pouvant être en silicium selon la revendication 1, **caractérisé en ce que** l'alliage SiₓGe_{y} est dopé.

3. Procédé pour contraindre un motif dans une couche de matériau semiconducteur pouvant être en silicium selon l'une des revendications 1 ou 2, **caractérisé en ce que** l'épaisseur de la couche d'alliage de SiₓGe_{y} est sensiblement égale à l'épaisseur critique au-delà de laquelle sont susceptibles d'apparaître des dislocations dans ladite couche d'alliage de SiₓGe_{y}.

4. Procédé pour contraindre un motif dans une couche de matériau semiconducteur pouvant être en silicium selon l'une des revendications 1 ou 2, **caractérisé en ce qu'**il comprend la détermination :
- d'une première fonction t_{SiGe} = f (W), relative à l'évolution d'une épaisseur optimale de la couche d'alliage SiₓGe_{y} (t_{SiGe}) en fonction d'une dimension de motif (W), permettant d'obtenir une contrainte maximum (SO_{ZZ}) dans ledit motif, ladite épaisseur optimale étant indépendante de la fraction molaire y ;
- d'une seconde fonction tc_{SiGe} = g (y) relative à l'évolution de l'épaisseur critique (tc_{SiGe}) de la couche d'alliage SiₓGe_{y} au-delà de laquelle des dislocations apparaissent dans ladite couche contrainte pour une fraction molaire y donnée ;
- la détermination d'une fraction molaire y par égalité des épaisseurs t_{SiGe} = tc_{SiGe}, permettant de définir pour une dimension de motif donnée, un couple optimal de valeurs (t_{SiG_optimum}, y_{_optimum}) ;
- la gravure en périphérie d'une surface de dimensions supérieures à celles de ladite surface de motif, de la couche d'oxyde de silicium enterrée et de la couche contrainte d'alliage SiₓGe_{y} avec y = y_{_optimum} et d'épaisseur optimale t_{SiGe_optimum}.

5. Procédé pour contraindre un motif dans une couche de matériau semiconducteur pouvant être en silicium selon l'une des revendications précédentes, **caractérisé en ce que** la gravure est effectuée également dans une partie dudit substrat sur une profondeur de gravure non nulle.

6. Procédé de fabrication de transistor **caractérisé en ce qu'**il comprend le procédé pour contraindre un motif selon l'une des revendications précédentes et comprenant la gravure d'une zone active dont la dimension (LZA) selon la direction du courant dans le plan des couches est au moins supérieure ou égale à la somme des dimensions d'une zone de source, d'une zone de grille et d'une zone de drain.

7. Procédé de fabrication de transistor selon la revendication 6, **caractérisé en ce qu'**il comprend :
- une étape de dépôt d'une couche de nitrure de silicium, postérieure à l'étape de gravure de la zone active ;
- une étape de dépôt épais de couche d'oxyde ;
- la réalisation de plots d'isolation d'oxyde de part et d'autre des zones de source, grille et drain.

## Patentansprüche

1. Verfahren zum Verspannen eines Musters, das eine als Muster bezeichnete Oberfläche aufweist, in einer Halbleitermaterialschicht, die aus Silicium sein kann, an der Oberfläche eines Schichtstapels, der an der Oberfläche eines Substrats ausgearbeitet ist, wobei der Stapel zumindest eine verspannte SiₓGe_{y}-Legierungsschicht, wobei x und y Stoffmengenanteile sind und der Stoffmengenanteil y gleich 1-x ist, und eine eingebettete Siliciumoxidschicht (BOX) umfasst, **dadurch gekennzeichnet, dass**:
- es das Ätzen am Rand einer Oberfläche mit Dimensionen, die größer sind als jene der Musteroberfläche, der eingebetteten Siliciumoxidschicht und der verspannten SiₓGe_{y}-Legierungsschicht, über die Tiefe der Legierungsschicht aufweist;
- wobei die druckverspannte SiₓGe_{y}-Schicht zumindest teilweise relaxiert wird während des die aktiven Zonen definierenden Ätzens, wobei eine Zugspannung in die Halbleitermaterialschicht, die aus Silicium sein kann, eingebracht wird;
- wobei sich die eingebettete Siliciumoxidschicht (BOX) zwischen der Halbleitermaterialschicht, die aus Silicium sein kann, und der verspannten SiₓGe_{y}-Legierungsschicht befindet.

2. Verfahren zum Verspannen eines Musters in einer Halbleitermaterialschicht, die aus Silicium sein kann, nach Anspruch 1, **dadurch gekennzeichnet, dass** die SiₓGe_{y}-Legierung dotiert ist.

3. Verfahren zum Verspannen eines Musters in einer Halbleitermaterialschicht, die aus Silicium sein kann, nach einem der Ansprüche 1 oder 2, **dadurch gekennzeichnet, dass** die Dicke der SiₓGe_{y}-Legierungsschicht im Wesentlichen gleich der kritischen Dicke ist, jenseits welcher möglicherweise Dislozierungen in der SiₓGe_{y}-Legierungsschicht auftreten.

4. Verfahren zum Verspannen eines Musters in einer Halbleitermaterialschicht, die aus Silicium sein kann, nach einem der Ansprüche 1 oder 2, **dadurch gekennzeichnet, dass** es die Bestimmung umfasst:
- einer ersten Funktion t_{SiGe} = f (W), bezogen auf die Entwicklung einer optimalen Dicke der SiₓGe_{y}-Legierungsschicht (t_{SiGe}) in Abhängigkeit von einer Musterdimension (W), die den Erhalt einer maximalen Verspannung (S0_{ZZ}) im Muster, wobei die optimale Dicke unabhängig vom Stoffmengenanteil y ist, ermöglicht;
- einer zweiten Funktion tc_{SiGe} = g (y), bezogen auf die Entwicklung der kritischen Dicke (tc_{SiGe}) der SiₓGe_{y}-Legierungsschicht, jenseits welcher Dislozierungen in der verspannten Schicht für einen gegebenen Stoffmengenanteil y auftreten;
- die Bestimmung eines Stoffmengenanteils y mittels Gleichheit der Dicken t_{SiGe} = tc_{SiGe}, der das Definieren, für eine gegebene Musterdimension, eines optimalen Wertepaars (t_{SiGe_Optimum}, y_{_Optimum}) ermöglicht;
- das Ätzen am Rand einer Oberfläche mit Dimensionen, die größer sind als jene der Musteroberfläche, der eingebetteten Siliciumoxidschicht und der verspannten SiₓGe_{y}-Legierungsschicht mit y = y_{_Optimum} und optimaler Dicke t_{SiGe_Optimum}.

5. Verfahren zum Verspannen eines Musters in einer Halbleitermaterialschicht, die aus Silicium sein kann, nach einem der vorstehenden Ansprüche, **dadurch gekennzeichnet, dass** das Ätzen auch in einem Teil des Substrats auf eine Ätztiefe ungleich null durchgeführt wird.

6. Verfahren zur Transistorherstellung, **dadurch gekennzeichnet, dass** es das Verfahren zum Verspannen eines Musters nach einem der vorstehenden Ansprüche umfasst, und umfassend das Ätzen einer aktiven Zone, deren Dimension (LZA) in der Richtung des Stroms in der Ebene der Schichten zumindest größer als oder genauso groß wie die Summe der Dimensionen einer Source-Zone, einer Gate-Zone und einer Drain-Zone ist.

7. Verfahren zur Transistorherstellung nach Anspruch 6, **dadurch gekennzeichnet, dass** es umfasst:
- einen Schritt zur Aufbringung einer Siliciumnitridschicht, nach dem Schritt des Ätzens der aktiven Zone;
- einen Schritt zur dicken Oxidschichtaufbringung;
- die Ausführung von Oxidisolationspads beiderseits der Zonen von Source, Gate und Drain.

## Claims

1. Method for stressing a pattern which has a so-called pattern surface into a layer of semiconductor material which may be of silicon on the surface of a stack of layers produced on the surface of a substrate, the stack comprising at least one stressed layer of alloy SiₓGe_{y} with x and y being molar fractions and the molar fraction y being equal to 1-x, and a layer of buried silicon oxide (BOX), **characterised in that**:
- it comprises the etching, at the periphery of a surface having dimensions greater than those of the pattern surface, of the layer of buried silicon oxide and the stressed layer of alloy SiₓGe_{y} over the depth of the layer of alloy;
- the stressed layer of SiₓGe_{y} in a compressed state being at least partially relaxed during the etching which defines the active zones, a tensile stress being induced in the layer of semiconductor material which may be of silicon,
- the layer of buried silicon oxide (BOX) being located between the layer of semiconductor material which may be of silicon and the stressed layer of alloy SiₓGe_{y}.

2. Method for stressing a pattern into a layer of semiconductor material which may be of silicon according to claim 1, **characterised in that** the alloy SiₓGe_{y} is doped.

3. Method for stressing a pattern into a layer of semiconductor material which may be of silicon according to either claim 1 or claim 2, **characterised in that** the thickness of the layer of alloy SiₓGe_{y} is substantially equal to the critical thickness beyond which dislocations are likely to appear in the layer of alloy SiₓGe_{y}.

4. Method for stressing a pattern into a layer of semiconductor material which may be of silicon according to either claim 1 or claim 2, **characterised in that** it comprises the determination of:
- a first function t_{SiGe} = f (W), relating to the development of an optimum thickness of the layer of alloy SiₓGe_{y} (t_{SiGe}) in accordance with a pattern dimension (W) which enables a maximum stress (S0_{ZZ}) to be obtained in the pattern, the optimum thickness being independent of the molar fraction y;
- a second function tc_{SiGe} = g (y) relating to the development of the critical thickness (tc_{SiGe}) of the layer of alloy SiₓGe_{y} beyond which dislocations appear in the stressed layer for a specific molar fraction y;
- the determination of a molar fraction y by means of equality of the thicknesses t_{SiGe} = tc_{SiGe} which enables the definition for a specific pattern dimension of an optimum pair of values (t_{SiG_optimum}, y_{_optimum});
- the etching, at the periphery of a surface having dimensions greater than those of the pattern surface, of the layer of buried silicon oxide and the stressed layer of alloy SiₓGe_{y} with y = y_{_optimum} and having an optimum thickness t_{SiGe_optimum}.

5. Method for stressing a pattern into a layer of semiconductor material which may be of silicon according to any one of the preceding claims, **characterised in that** the etching is also carried out in a portion of the substrate over an etching depth which is not equal to zero.

6. Method for producing a transistor, **characterised in that** it comprises the method for stressing a pattern according to any one of the preceding claims and comprising the etching of an active zone whose dimensions (LZA) in the direction of the current in the plane of the layers is at least greater than or equal to the sum of the dimensions of a source zone, a grid zone and a drain zone.

7. Method for producing a transistor according to claim 6, **characterised in that** it comprises:
- a step of depositing a layer of silicon nitride, following the step of etching the active zone;
- a step of thick deposit of a layer of oxide;
- the production of insulating studs of oxide at one side and the other of the source, grid and drain zones.
